**Europäisches Patentamt**

**European Patent Office**

**Office européen des brevets**

(19)

(11) Numéro de publication : **0 378 016 B1**

# (12) FASCICULE DE BREVET EUROPEEN

(45) Date de publication du fascicule du brevet :
**08.04.92 Bulletin 92/15**

(51) Int. Cl.$^5$ : **H05K 1/00,** H05K 1/11

(21) Numéro de dépôt : **89403360.4**

(22) Date de dépôt : **05.12.89**

(54) **Dispositif de raccordement de composants et module fonctionnel l'utilisant.**

(30) Priorité : **09.12.88 FR 8816214**

(43) Date de publication de la demande :
**18.07.90 Bulletin 90/29**

(45) Mention de la délivrance du brevet :
**08.04.92 Bulletin 92/15**

(84) Etats contractants désignés :
**DE GB IT NL**

(56) Documents cités :
**DE-U- 8 801 970**
**FR-A- 1 187 819**
**FR-A- 2 305 914**
**FR-A- 2 441 315**

(73) Titulaire : **THOMSON-CSF**
**51, Esplanade du Général de Gaulle**
**F-92800 Puteaux (FR)**

(72) Inventeur : **Prevost, Michel**
**THOMSON-CSF SCPI Cédex 67**
**F-92045 Paris la Défense (FR)**

(74) Mandataire : **Albert, Claude et al**
**THOMSON-CSF SCPI**
**F-92045 PARIS LA DEFENSE CEDEX 67 (FR)**

EP 0 378 016 B1

**Description**

La présente invention a pour objet un dispositif de raccordement de composants qui est susceptible de porter un composant, et qui est par exemple destiné à être connecté à d'autres dispositifs du même type, qui sont chacun susceptibles de porter un composant. L'invention concerne également un module fonctionnel comportant une pluralité de tels dispositifs de raccordement.

Dans ce qui précède et dans ce qui suit, on désigne sous le terme général "composant" tout composant actif ou passif, tout composant discret ou tout ensemble de composants formant un circuit intégré, qui comporte des zones de connexion disposées sur au moins une partie d'une surface sensiblement plane.

Pour réaliser un circuit électrique, il est nécessaire d'interconnecter des composants. Pour les matériels actuels, on cherche à réaliser de telles connexions de la façon la plus compacte possible. Il est également intéressant de réaliser du matériel standardisé ou bien de trouver un compromis entre compacité et standardisation, ces deux résultats étant souvent antinomiques.

On connaît les cartes imprimées multicouches : celles-ci sont constituées de plaques isolantes empilées, assemblées les unes aux autres ; chaque plaque comporte des pistes conductrices d'électricité réalisées au moins sur une face, les pistes de toutes les plaques étant par exemple réalisées sur des faces orientées du même côté de l'empilement ; les pistes de plaques différentes sont interconnectées par des trous métallisés ; des composants sont connectés à certaines de ces pistes par exemple par l'intermédiaire de trous métallisés ; enfin, le circuit imprimé comporte des moyens de connexion avec l'extérieur connus en soi. Un tel dispositif est, par exemple, connu de FR-A-2305 914

Le nombre de couches, le dessin des pistes sur chaque couche, l'emplacement des trous métallisés, sont déterminés en fonction de l'application du circuit imprimé, c'est-à-dire de l'interconnexion désirée.

L'invention a pour objet un dispositif de raccordement de composants qui est plus standardisé qu'un circuit imprimé. Ce dispositif de raccordement de composants comporte des lamelles isolantes empilées et assemblées sur lesquelles sont réalisées, sur les faces orientées d'un côté prédéterminé de l'empilement, des pistes conductrices sensiblement rectilignes et parallèles entre elles, les pistes de deux lamelles adjacentes étant sensiblement perpendiculaires les unes aux autres. Le dessin des pistes sur chaque lamelle est donc indépendant de l'application du dispositif. Ce dispositif permet néanmoins de réaliser diverses interconnexions entre composants grâce à sa modularité : ce dispositif est susceptible de porter un composant et d'être connecté à d'autres dispositifs du même type susceptibles eux aussi de porter un composant; le dispositif comporte, en effet, des zones de connexion pour un composant, situées sur celle qui est libre des faces qui comportent des pistes, et les pistes de chaque lamelle sont prolongées sur la tranche de celle-ci formant ainsi des zones de connexion avec l'extérieur. Le dispositif comporte en outre des moyens de connexion entre les zones de connexion pour un composant et les pistes des autres faces.

L'invention a plus précisément pour objet un dispositif de raccordement de composants comportant :
- une pluralité de premières lamelles empilées, réalisées dans un matériau électriquement isolant, chaque première lamelle comportant une pluralité de pistes conductrices d'électricité réalisées sur une première de ses faces, toutes lesdites premières faces des premières lamelles étant orientées du même côté ;
- des moyens d'assemblage mécanique des premières lamelles, le dispositif étant caractérisé en ce que :
- les pistes conductrices d'une première lamelle donnée sont sensiblement rectilignes, sensiblement parallèles entre elles ;
- les pistes conductrices de deux premières lamelles adjacentes sont sensiblement perpendiculaires ;

et en ce qu'il comporte en outre :
- sur celle desdites premières faces qui est libre, des zones pour la connexion d'un composant ;
- des moyens de connexion électrique entre des pistes appartenant auxdites premières faces qui ne sont pas libres et lesdites zones pour la connexion d'un composant ;
- sur la tranche de chacune des lamelles, des zones de connexion avec l'extérieur situées dans le prolongement desdites pistes conductrices.

L'invention concerne également un module fonctionnel comportant une pluralité de tels dispositifs de raccordement de composants.

Des précisions, des particularités, et différents modes de réalisation de l'invention apparaîtront au cours de la description qui suit, à l'aide des figures annexées qui représentent :
- la figure 1, un mode de réalisation d'un dispositif de raccordement de composants selon l'invention, représenté isolément ;
- la figure 2, le dispositif de la figure 1 associé au composant qui lui est connecté ;
- la figure 3, une première coupe d'un mode de réalisation d'un module fonctionnel selon l'invention ;
- la figure 4, une seconde coupe du dispositif de la figure 3.

Sur ces différentes figures d'une part l'échelle réelle n'a pas été respectée, et d'autre part les mêmes références se rapportent aux mêmes éléments.

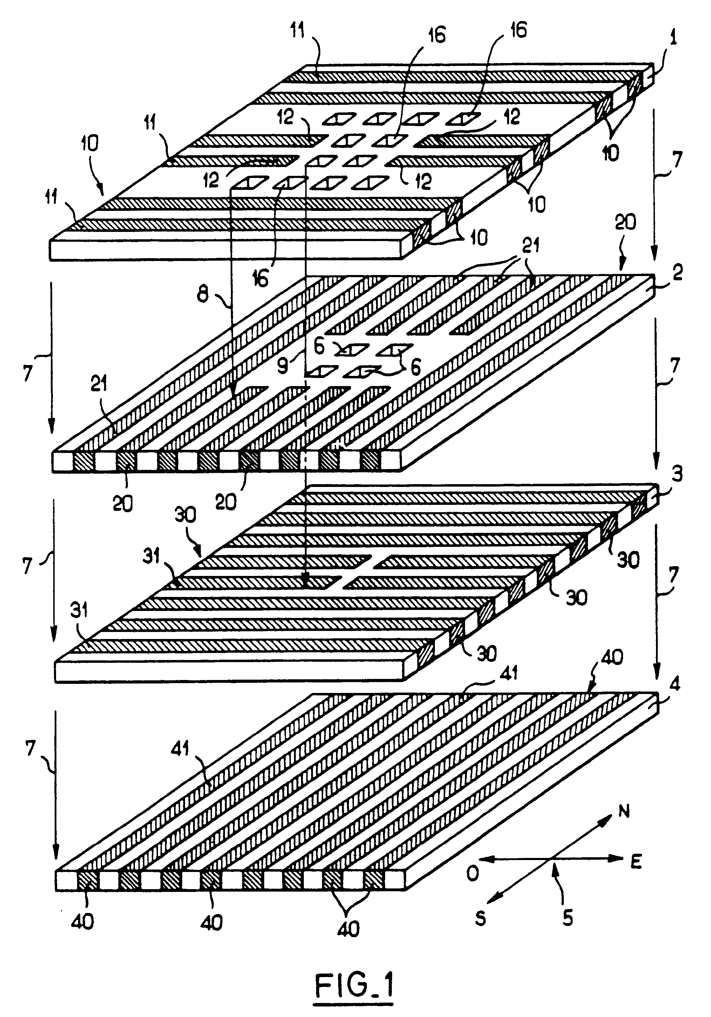

La figure 1 représente en vue éclatée, comme le montrent les flèches 7, un premier mode de réalisation d'un dispositif de raccordement de composants selon l'invention.

Ce dispositif comporte quatre lamelles électriquement isolantes 1, 2, 3 et 4 empilées, sur chacune desquelles sont réalisées, par exemple par sérigraphie, des pistes conductrices d'électricité 11, 21; 31 et 41 ces pistes se trouvent sur celles des faces des lamelles 1, 2, 3 et 4 qui sont orientées d'un côté donné, comme par exemple vers le dessus du dispositif qui se trouve, sur la figure 1, du côté de la lamelle 1. Les pistes d'une lamelle donnée sont sensiblement rectilignes et parallèles entre elles.

Les pistes de deux lamelles adjacentes sont sensiblement perpendiculaires : dans un repère géographique 5 comportant les quatre points cardinaux, les pistes 11 et 31 des lamelles 1 et 3 sont par exemple orientées dans le sens est-ouest (E/O) les pistes 21 et 41 des lamelles 2 et 4 sont alors orientées dans le sens nord-sud (N/S). Des trous 6, sensiblement perpendiculaires à l'empilement de lamelles, relient des pistes appartenant aux lamelles 2, 3 ou 4 à des zones de la face libre de la lamelle 1, comme schématisé par les flèches 8 et 9 : sur la figure 1, huit trous relient des pistes de la lamelle 2 à la lamelle 1 (ce qu'indique la flèche 8) et quatre trous relient des pistes de la lamelle 3 à la lamelle 1 (ce qu'indique la flèche 9).

Le dispositif de la figure 1 est destiné recevoir, du côté de la lamelle 1, un composant dont les zones de connexion sont par exemple disposées selon un quadrillage Q sensiblement régulier : la lamelle 1 comporte à cet effet soit des extrémités 12 de pistes 11 ou soit des extrémités 16 des trous 6 placés selon sensiblement le même quadrillage Q ; ces extrémités 12 ou 16 de pistes ou de trous constituent des zones de connexion pour un composant qui sont par exemple soudées aux zones de connexion du composant : à cet effet les trous 6 sont par exemple remplis d'un matériau conducteur d'électricité (comme par exemple un métal) les surfaces de ces trous pleins constituant ainsi les extrémités 16 de trous 6.

Le quadrillage Q des zones pour la connexion d'un composant du dispositif fixe le nombre et la répartition des pistes de la lamelle 1 qui sont reliées à des extrémités 12 et des pistes des autres lamelles qui sont reliées à des trous 6. Le nombre et la répartition des autres pistes sont fonction de l'application du dispositif.

Le remplissage des trous 6 avec un matériau conducteur d'électricité assure en outre une fonction d'assemblage mécanique des lamelles qui sont électriquement connectées à la face libre de la lamelle 1 ; dans le cas de la figure 1, un tel remplissage assemble les lamelles 1, 2 et 3 ; les lamelles non connectées à la face libre de la lamelle 1, comme la lamelle 4 de la figure 1, sont assemblées aux autres lamelles par exemple par collage.

Le remplissage des trous 6 assure également une évacuation de chaleur au sein du dispositif.

D'autre part, pour connecter le dispositif de la figure 1 avec l'extérieur, comme par exemple à d'autres dispositifs analogues, susceptibles eux aussi de porter d'autres composants, les pistes de chacune des lamelles se prolongent sur la tranche de ces lamelles en des zones, dites de connexion avec l'extérieur dans ce qui suit, et référencés 10, 20, 30 et 40.

Le dispositif de la figure 1 assure donc une transmission de signaux entre lesdites zones pour la connexion d'un composant situé sur la face libre de la lamelle 1 (c'est-à-dire les extrémités 12 de pistes 11 ou les extrémités 16 de trous 6) et les zones de connexion avec l'extérieur (c'est-à-dire les prolongements des pistes sur la tranche des lamelles) qui sont dirigées vers le nord, le sud, l'est ou l'ouest du dispositif dans le repère géographique 5. Dans l'exemple illustré par la figure 1, le dispositif comporte seize zones pour la connexion dont :

- deux sont reliées à l'est et sortent par la lamelle 1 ;
- deux sont reliées à l'ouest et sortent par la lamelle 1 ;
- quatre sont reliées au nord et sortent par la lamelle 2 ;
- quatre sont reliées au sud et sortent par la lamelle 2 ;
- deux sont reliées à l'est et sortent par la lamelle 3 ;
- deux sont reliées à l'ouest et sortent par la lamelle 3.

La lamelle 4 du dispositif de la figure 1 permet d'assurer une transmission de signaux "directe", c'est-à-dire sans passer par le composant raccordé au dispositif de la façon précédemment décrite : le dispositif est en effet destiné à être inséré dans un ensemble, comme par exemple dans un module fonctionnel tel que celui décrit dans ce qui suit, et il peut être nécessaire de réaliser des pistes 40 traversant directement le dispositif. Le nombre de lamelles du dispositif dépend donc de l'application de ce dispositif.

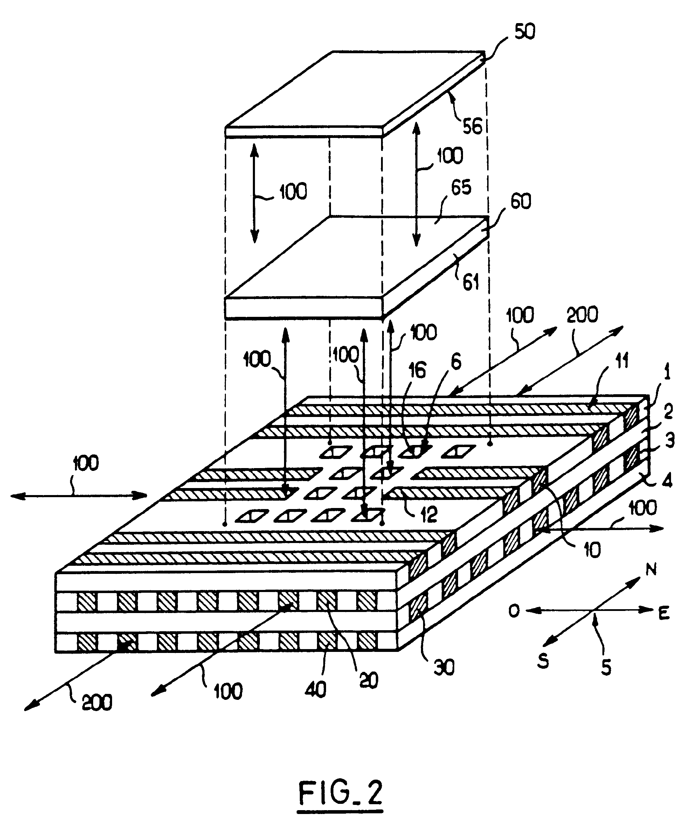

La figure 2 illustre plus précisément le fonctionnement du dispositif de la figure 1 : celle-ci représente en effet le dispositif de la figure 1 assemblé, ainsi qu'un composant 50, représenté écarté du dispositif de raccordement comme l'indiquent les pointillés. En raison des tailles respectives des zones de connexion du composant 50 (non représentées sur la figure 2) et des zones pour la connexion 12 et 16 du dispositif de raccordement (précédemment décrites), il peut s'avérer nécessaire d'intercaler entre le composant 50 et le dispositif de raccordement des moyens d'interconnexion et de fixation 60 ; c'est en particulier le cas lorsque le composant est un circuit intégré : la finesse de réalisation des plots du circuit intégré est alors nettement supérieure à celle qu'il est possible d'atteindre lors de la réalisation d'un dispositif de raccordement selon l'invention.

Ces moyens d'interconnexion et de fixation 60 sont par exemple constitués d'une lamelle dont les deux faces 65 et 61 sont respectivement situées contre la face 56 du composant qui comporte des zones de connexion et contre la face libre de la lamelle 1. Ces deux faces 65 et 61 comportent chacune des zones de connexion (non représentées sur la figure 2) de finesse de réalisation intermédiaire entre celle des zones de connexion du composant et celle des extrémités 12 des pistes 11 ou des extrémités 16 de trous 6. Les zones de connexion des faces 65 et 61 sont électriquement reliées par des voies traversant la lamelle 60. De préférence, au moins une partie de ces voies assure un déplacement sensiblement parallèle aux faces 65 et 61. D'autre part, les zones de connexion des faces 65 et 61 sont par exemple soudées respectivement à celles du composant 50 et aux extrémités 12 ou 16 de pistes 11 ou de trous 6, ce qui assure en outre une fixation mécanique entre le composant 50, la lamelle 60, et le dispositif de raccordement.

Selon un mode de réalisation préféré, les moyens d'interconnexion et de fixation 60 sont constitués d'un dispositif d'interconnexion connu tel que celui décrit dans EP-A-0353114 : les faces 65 et 61 représentées sur la figure 2 sont alors respectivement la première face et la seconde face de la première variante (comportant une lamelle) du dispositif d'interconnexion connu, ou bien la première face de la première lamelle et la seconde face de la nième lamelle de la seconde variante (comportant n lamelles) du dispositif d'interconnexion connu.

Des signaux peuvent donc être transmis dans les directions indiquées par les flèches 100 entre le composant 50 et l'extérieur, ou bien traverser directement le composant, comme expliqué précédemment, dans la direction indiquée par les flèches 200, c'est-à-dire, dans l'exemple des figures 1 et 2, dans la direction nord-sud.

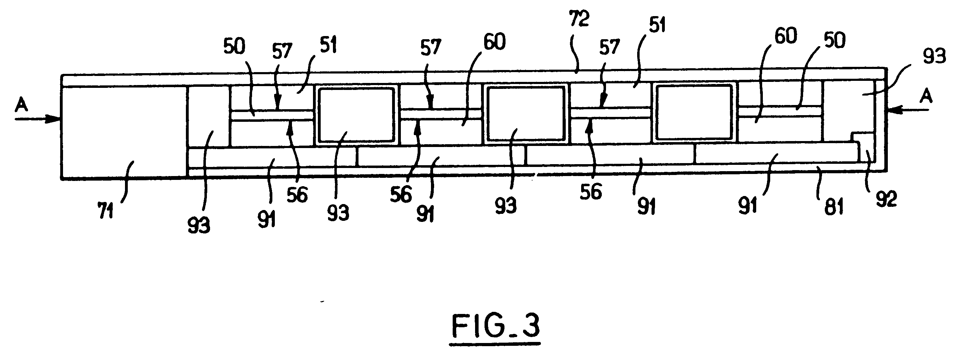

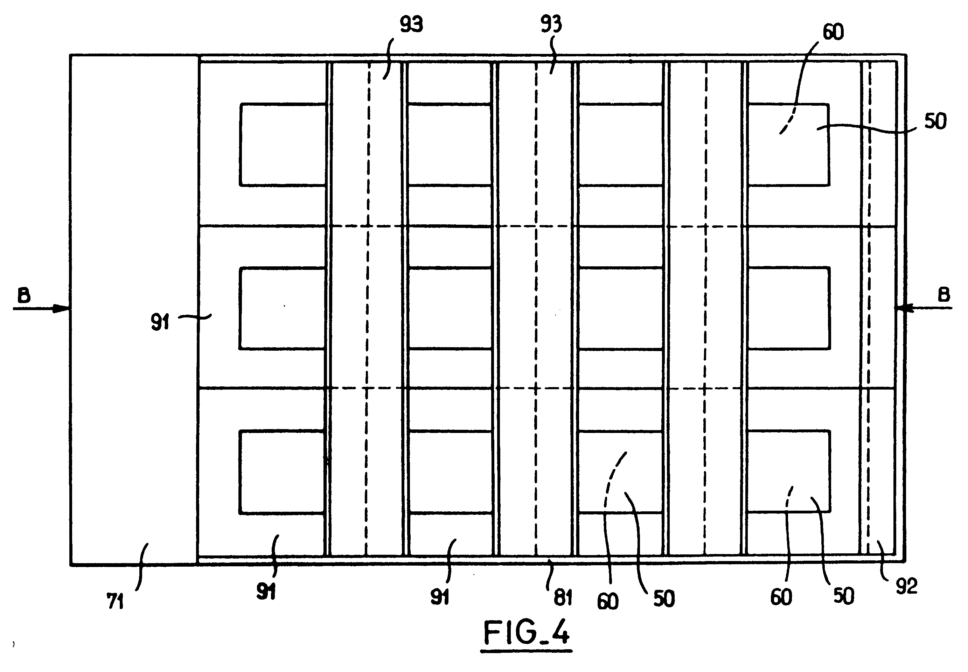

Les figures 3 et 4 représentent respectivement une première et une seconde coupe d'un mode de réalisation d'un module fonctionnel selon l'invention, comportant une pluralité de dispositifs de raccordements selon l'invention tels que, par exemple, celui des figures 1 et 2. Le plan de coupe de la figure 4 est indiqué sur la figure 3 par les flèches A-A. Réciproquement, le plan de coupe de la figure 3 est repéré par les flèches B-B sur la figure 4. Les figures 3 et 4 sont décrites simultanément.

Le module fonctionnel décrit comporte par exemple douze dispositifs de raccordement 91. A chaque dispositif de raccordement est connecté et fixé un composant 50 par exemple par des moyens d'interconnexion et de fixation 60 tels que ceux mentionnés dans la description de la figure 2.

Les dispositifs de raccordement 91 sont juxtaposés au fond d'un coffret 81 dont une paroi latérale 71 est par exemple constituée d'un connecteur susceptible d'assurer une liaison électrique avec l'extérieur. Le coffret contient également les composants 50 et les moyens d'interconnexion et de fixation 60. Il comporte un couvercle 72 constitué par exemple d'une plaque d'un matériau conducteur de chaleur, appelée plaque froide dans ce qui suit : cette plaque assure une fonction d'évacuation de chaleur hors du module fonctionnel et de rigidification de ce module fonctionnel. Les tranches des dispositifs de raccordement 91 sont maintenues en contact les unes avec les autres par des moyens de compression 92 comportant par exemple des ressorts et connus en euxmêmes.

Selon un mode de réalisation préféré, les composants 50 sont des lamelles sensiblement carrées ; les moyens d'interconnexion 60, et les dispositifs de raccordement 91 sont aussi sensiblement carrés ; les dimensions des composants 50 sont sensiblement les mêmes que celles des moyens d'interconnexion 60 et sont inférieures à celles des dispositifs de raccordement 91 ; des espaces 93 sont ainsi laissés libres à l'intérieur du coffret ; certains de ces espaces libres 93 peuvent par exemple être utilisés pour loger des canaux au sein desquels circule un fluide caloporteur ; ces canaux sont de préférence en contact avec la plaque froide 72, et améliorent l'évacuation de la chaleur hors du module fonctionnel. Afin d'évacuer encore plus de chaleur, il est en outre possible de répandre un matériau conducteur de chaleur dans les espaces libres ne contenant pas de canaux 93 dans ce cas, la plaque froide 72 ferme le module fonctionnel de façon étanche.

A titre d'exemple, les composants 50 sont des circuits intégrés, et chacun de ceux-ci est connecté à un condensateur 51 assurant une fonction de découplage, comme par exemple un condensateur multicouches, connu en soi par l'homme du métier. Un tel condensateur 51 a par exemple la forme d'une lamelle sensiblement carrée et a de préférence sensiblement les mêmes dimensions que le circuit intégré 50. Le condensateur 51 est placé dans le coffret 81 contre la face 57 du circuit intégré 50 (qui est opposée à la face 56 portant des zones de connexion et située contre les moyens d'interconnexion et de fixation 60). Le condensateur 51 et le circuit intégré 50 sont par exemple interconnectés et fixés de la façon décrite dans FR-A-2638894.

## Revendications

1. Dispositif de raccordement de composants comportant :

    – une pluralité de premières lamelles (1, 2, 3, 4) empilées, réalisées dans un matériau électriquement isolant, chaque première lamelle (1, 2, 3, 4) comportant une pluralité de pistes conductrices d'électricité (11, 21, 31, 41) réalisées sur une première de ses faces, toutes lesdites premières faces des premières lamelles (1, 2, 3, 4) étant orientées du même côté ;

– des moyens d'assemblage mécanique (6) des premières lamelles (1, 2, 3, 4),

– les pistes conductrices (11, 21, 31, 41) d'une première lamelle donnée étant sensiblement rectilignes et sensiblement parallèles entre elles ;

– les pistes conductrices (11, 21 ; 21, 31 ; 31, 41) de deux premières lamelles adjacentes étant sensiblement perpendiculaires ; caractérisé en ce qu'il comporte en outre :

– sur celle desdites premières faces qui est libre, des zones (12, 16) de connexion pour un composant ;

– des moyens de connexion électrique (6) entre des pistes (21, 31) appartenant auxdites premières faces quine sont pas libres et lesdites zones (12, 16) de connexion d'un composant ;

– sur la tranche de chacune des lamelles (1, 2, 3, 4), des zones de connexion avec l'extérieur (10, 20, 30, 40) situées dans le prolongement desdites pistes conductrices (11, 21, 31, 41).

2. Dispositif selon la revendication 1, caractérisé en ce que les moyens d'assemblage (6) des premières lamelles (1, 2, 3, 4) et les moyens de connexion (6) entre des pistes (21, 31) appartenant auxdites premières faces quine sont pas libres et lesdites zones (12, 16) pour la connexion d'un composant comportent des trous remplis d'un matériau conducteur d'électricité.

3. Dispositif selon la revendication 2, caractérisé en ce que les moyens d'assemblage (6) des premières lamelles (1, 2, 3, 4) comportent en outre de la colle entre les lamelles (4) dont les pistes ne sont pas connectées auxdites zones (12, 16) pour la connexion d'un composant et les lamelles adjacentes (3).

4. Dispositif selon l'une des revendications 1 à 3, caractérisé en ce que les zones (12, 16) pour la connexion d'un composant comportent des extrémités (12) de pistes (11) situées sur celle desdites premières faces qui est libre et des extrémités (16) de trous pleins (6).

5. Dispositif selon l'une des revendications précédentes, caractérisé en ce que les pistes (11, 21, 31, 41) sont des bandes étroites desdites premières faces des premières lamelles (1, 2, 3, 4) qui sont sérigraphiées.

6. Dispositif selon l'une des revendications précédentes, caractérisé en ce que lesdites zones de connexion avec l'extérieur (10, 20, 30, 40) sont des bandes étroites sérigraphiées.

7. Module fonctionnel, caractérisé en ce qu'il comporte :

– une pluralité de composants (50) ;

– une pluralité de dispositifs de raccordement juxtaposés (91) selon l'une des revendications précédentes ;

– des moyens d'interconnexion et de fixation (60) entre les composants (50) et les dispositifs de raccordement (91) ;

– des moyens d'assemblage mécanique (81, 71, 72, 92) des dispositifs de raccordement assurant un contact entre leurs tranches;

– des moyens de connexion (71) du module fonctionnel avec l'extérieur.

8. Module selon la revendication 7, caractérisé en ce que les moyens d'assemblage (81, 71, 72, 92) mécanique comportent :

– un coffret (81) au fond duquel sont juxtaposés les dispositifs de raccordement (91) et contenant les composants (50) et les moyens d'interconnexion et de fixation (60) ;

– des moyens de compression (92).

9. Module selon la revendication 8, caractérisé en ce que les moyens d'interconnexion et de fixation (60) comportent au moins une seconde lamelle dont une face (65) se trouve contre celle (56) des faces du composant (50) qui comporte des zones de connexion et comporte elle-même des premières zones de connexion situées en regard de celles du composant, et dont l'autre face (61) est située contre celle desdites premières faces du dispositif de raccordement qui est libre et comporte des secondes zones de connexion situées en regard des zones (12, 16) pour la connexion d'un composant du dispositif de raccordement (91), les premières et secondes zones de connexion de la seconde lamelle étant électriquement reliées par des voies assurant au moins pour partie un déplacement sensiblement parallèle aux faces de la seconde lamelle, les zones de connexion de la seconde lamelle étant de finesse de réalisation intermédiaire entre celle des zones de connexion du composant (50) et celle des zones (12, 16) pour la connexion d'un composant du dispositif de raccordement (91).

10. Module selon la revendication 9, caractérisé en ce que les dimensions des faces de la seconde lamelle et celles du composant (50) sensiblement parallèlement aux faces de la seconde lamelle sont inférieures à celles desdites premières lamelles (1, 2, 3, 4) du dispositif de raccordement (91), ce qui ménage des espaces libres (93) dans le coffret (81).

11. Module selon l'une des revendications 9 ou 10, caractérisé en ce que lesdits moyens d'interconnexion et de fixation (60) comportent en outre des soudures réalisées entre lesdites premières zones de connexion de ladite seconde lamelle et les zones de connexion du composant (50), et entre lesdites secondes zones d'interconnexion de ladite seconde lamelle et les zones (12, 16) pour la connexion d'un composant du dispositif de raccordement (91).

12. Module selon l'une des revendications 7 à 11, caractérisé en ce qu'il comporte en outre des moyens de refroidissement.

13. Module selon la revendication 12, caractérisé en ce que les moyens de refroidissement comportent une plaque froide (72) constituant une des parois (71) du coffret (81).

14. Module selon l'une des revendication 12 ou 13, caractérisé en ce que les moyens de refroidissement comportent des canaux réalisés dans lesdits espaces libres (93) et au sein desquels circule un fluide caloporteur.

15. Module selon l'une des revendications 12 à 14, caractérisé en ce que les moyens de refroidissement comportent un matériau conducteur de chaleur et isolant électriquement répandu dans le coffret (81) autour des dispositifs de raccordement (91), des composants (50), et desdits moyens d'interconnexion et de fixation (60).

16. Module selon l'une des revendications 7 à 15, caractérisé en ce que chaque composant (50) est un circuit intégré et en ce que le module comporte en outre une pluralité de condensateurs (51) assurant une fonction de découplage pour les circuits intégrés (50), un condensateur (51) étant connecté et fixé à chacun des circuits intégrés (50).

## Patentansprüche

1. Einrichtung für die Verbindung von Bauteilen, mit:
– einer Mehrzahl von ersten geschichteten Lamellen (1, 2, 3, 4) aus einem elektrisch isolierenden Material, wobei jede erste Lamelle (1, 2, 3, 4) eine Mehrzahl von auf einer ersten ihrer Seiten verwirklichten elektrisch leitenden Bahnen (11, 21, 31, 41) aufweist, wobei sämtliche erste Seiten der ersten Lamellen (1, 2, 3, 4) dieselbe Orientierung besitzen;
– Mitteln für die mechanische Zusammenfügung (6) der ersten Lamellen (1, 2, 3, 4),
– wobei die leitenden Bahnen (11, 21, 31, 41) einer gegebenen ersten Lamelle im wesentlichen geradlinig und im wesentlichen zueinander parallel sind;
– wobei die leitenden Bahnen (11, 21; 21, 31; 31, 41) von zwei benachbarten ersten Lamellen im wesentlichen zueinander senkrecht orientiert sind, dadurch gekennzeichnet, daß sie außerdem umfaßt:
– Anschlußzonen (12, 16) für ein Bauteil (50) auf der freiliegenden Seite der ersten Seiten;
– Mittel für die elektrische Verbindung (6) zwischen den Bahnen (21, 31), die den nicht freiliegenden ersten Seiten zugehören, und den Zonen (12, 16) für den Anschluß eines Bauteils (50);
– an der Schnittfläche einer jeden der Lamellen (1, 2, 3, 4) befindliche Zonen für die Verbindung nach außen (10, 20, 30, 40), die sich in der Verlängerung der leitenden Bahnen (11, 12, 31, 41) befinden.

2. Einrichtung gemäß Anspruch 1, dadurch gekennzeichnet, daß die Mittel für die Zusammenfügung (6) der ersten Lamellen (1, 2, 3, 4) und die Mittel für die Verbindung (6) zwischen denjenigen Bahnen (21, 31), die den nicht freiliegenden ersten Seiten zugehören, und den Zonen (12, 16) für den Anschluß eines Bauteils Löcher aufweisen, die mit einem elektrisch leitenden Material gefüllt sind.

3. Einrichtung gemäß Anspruch 2, dadurch gekennzeichnet, daß die Mittel für die Zusammenfügung (6) der ersten Lamellen (1, 2, 3, 4) außerdem zwischen denjenigen Lamellen (4), deren Bahnen nicht mit den Zonen (12, 16) für den Anschluß eines Bauteils verbunden werden, und den benachbarten Lamellen (3) einen Klebstoff umfassen.

4. Einrichtung gemäß einem der Ansprüche 1 bis 3, dadurch gekennzeichnet, daß die Zonen (12, 16) für den Anschluß eines Bauteils Enden (12) von auf der freiliegenden Seite der ersten Seite befindlichen Bahnen (11) und Enden (16) von gefüllten Löchern (6) umfassen.

5. Einrichtung gemäß einem der vorangehenden Ansprüche, dadurch gekennzeichnet, daß die Bahnen (11, 21, 31, 41) schmale Streifen der ersten Seiten der ersten Lamellen (1, 2, 3, 4) sind, die mittels Siebdrucks hergestellt sind.

6. Einrichtung gemäß einem der vorangehenden Ansprüche, dadurch gekennzeichnet, daß die Zonen für die Verbindung nach außen (10, 20, 30, 40) mittels Siebdrucks hergestellte schmale Streifen sind.

7. Funktionsmodul, dadurch gekennzeichnet, daß er umfaßt:
– eine Mehrzahl von Bauteilen (50);
– eine Mehrzahl von nebeneinander angeordneten Verbindungseinrichtungen (91) gemäß einem der vorangehenden Ansprüche;
– Mittel für die Verbindung und die Befestigung (60) der Bauteile (50) mit den Verbindungseinrichtungen (91);
– Mittel für die mechanische Zusammenfügung (81, 71, 72, 92) der Verbindungseinrichtungen, die einen Kontakt zwischen deren Schnittflächen gewährleisten;
– Mittel für die Verbindung (71) des Funktionsmoduls mit der äußeren Umgebung.

8. Modul gemäß Anspruch 7, dadurch gekennzeichnet, daß die Mittel für die mechanische Zusammenfügung (81, 71, 72, 92) umfassen:
– einen Kasten (81), auf dessen Boden die Verbindungseinrichtungen (91) nebeneinanderliegen und der die Bauteile (50) und die Verbindungs- und Befestigungsmittel (60) enthält;
– Pressungsmittel (92).

9. Modul gemäß Anspruch 8, dadurch gekennzeichnet, daß die Verbindungs- und Befestigungsmittel (60) wenigstens eine zweite Lamelle aufweisen, von der sich eine Seite (65) gegenüber derjenigen (56) der Seiten des Bauteils (50) befindet, die die Anschlußzonen aufweist, und die selbst erste Anschlußzonen besitzt, die gegenüber denjenigen des Bauteils angeordnet sind, und deren andere Seite (61) gegenüber der freiliegenden Seite der ersten Seiten der Verbindungseinrichtung angeordnet ist und zweite Anschlußzonen aufweist, die sich gegenüber den Anschlußzonen (12, 16) für ein Bauteil der Verbindungseinrichtung (91) befinden, wobei die ersten und die zweiten Anschlußzonen der zweiten Lamelle über Pfade, die wenigstens teilweise eine zu den Seiten der zweiten Lamelle im wesentlichen parallele Verschiebung gewährleisten, elektrisch verbunden sind, wobei die Anschlußzonen der zweiten Lamelle von einer Herstellungsfeinheit sind, die zwischen derjenigen der Anschlußzonen des Bauteils (50) und derjenigen der Zonen (12, 16) für den Anschluß eines Bauteils der Verbindungseinrichtung (91) liegt.

10. Modul gemäß Anspruch 9, dadurch gekennzeichnet, daß die Abmessungen der Seiten der zweiten Lamelle und derjenigen des Bauteils (50), die zu den Seiten der zweiten Lamelle im wesentlichen parallel sind, geringer als diejenigen der ersten Lamellen (1, 2, 3, 4) der Verbindungseinrichtung (91) sind, wodurch im Kasten (81) freie Räume (93) geschaffen werden.

11. Modul gemäß einem der Ansprüche 9 oder 10, dadurch gekennzeichnet, daß die Verbindungs- und Befestigungsmittel (60) außerdem Lötstellen aufweisen, die zwischen den ersten Anschlußzonen der zweiten Lamelle und den Zonen für den Anschluß des Bauteils (50) und zwischen den zweiten Verbindungszonen der zweiten Lamelle und den Zonen (12, 16) für den Anschluß eines Bauteils der Verbindungseinrichtung (91) verwirklicht sind.

12. Modul gemäß einem der Ansprüche 7 bis 11, dadurch gekennzeichnet, daß er außerdem Kühlungsmittel umfaßt.

13. Modul gemäß Anspruch 12, dadurch gekennzeichnet, daß die Kühlungsmittel eine Kühlungsplatte (72), die eine der Wände (71) des Kastens (81) bildet, aufweisen.

14. Modul gemäß einem der Ansprüche 12 oder 13, dadurch gekennzeichnet, daß die Kühlungsmittel Kanäle aufweisen, die in den freien Räumen (93) verwirklicht sind und in denen ein Kühlungsmittel zirkuliert.

15. Modul gemäß einem der Ansprüche 12 bis 14, dadurch gekennzeichnet, daß die Kühlungsmittel ein wärmeleitendes und elektrisch isolierendes Material aufweisen, das im Kasten (81) um die Verbindungseinrichtungen (91), die Bauteile (50) und die Verbindungs- und Befestigungsmittel (60) verteilt ist.

16. Modul gemäß einem der Ansprüche 7 bis 15, dadurch gekennzeichnet, daß jedes Bauteil (50) eine integrierte Schaltung ist und daß der Modul außerdem eine Mehrzahl von Kondensatoren (51) umfaßt, die für die integrierten Schaltungen (50) eine Entkopplungsfunktion gewährleisten, wobei ein Kondensator (51) mit jeder der integrierten Schaltungen (50) verbunden und an dieser befestigt ist.

## Claims

1. A device for the connection of components comprising:
– a plurality of first stacked sheets (1, 2, 3 and 4) made of an electrically insulating material, each first sheet (1, 2, 3 and 4) comprising a plurality of electricity conducting tracks (11, 21 31 and 41) produced on a first one of the faces thereof, all the said first faces of the first sheets (1, 2, 3 and 4) being directed the same way:
– mechanical assembly means (6) for the first sheets (1, 2, 3 and 4), - the conducting tracks (11, 21, 31 and 41) of a first given sheet being substantially rectangular and generally parallel to each other,
– the conducting tracks (11, 21; 21, 31; 31 and 41) of the two first adjacent sheets being generally perpendicular, characterized in that it furthermore comprises:
– on that one of the first faces, which is free, zones (12 and 16) for the connection of a component (50),
– electrical connection means (6) between the tracks (21 and 31) belonging to the said first faces which are not free and the said zone (12 and 16) for the connection of a component (50),
– and on the edge of each of the sheets (1, 2, 3 and 4), zones for connection with the outside (10, 20, 30 and 40) positioned in the prolongation of the said conducting tracks (11, 21, 31 and 41).

2. The device as claimed in claim 1, characterized in that the assembly means (6) of the first sheets (1, 2, 3 and 4) and the connection means (6) between the tracks (21 and 31) belonging to the said first faces which are not free, and the said zones (12 and 16) for the connection of a component comprise holes filled with a material conducting electricity.

3. The device as claimed in claim 2, characterized in that the assembly means (6) of the first sheets (1, 2, 3 and 4) furthermore comprise adhesive between the sheets (4) whose tracks are not connected with the said zones (12 and 16) for the connection of a component and the adjacent sheets (3).

4. The device as claimed in any one of the preceding claims 1 through 3, characterized in that the zones (12 and 16) for the connection of a component comprise ends (12) of tracks (11) positioned on that one of the first said faces which is free and of the ends (16) of the full holes (6).

5. The device as claimed in any one of the preceding claims, characterized in that the tracks (11, 21, 31 and 41 ) are narrow bands of the first faces of the first sheets (1, 2, 3 and 4) which are screen printed.

6. The device as claimed in any one of the preceding claims, characterized in that the said zones for connection with the outside (10, 20, 30 and 40) are narrow screen printed bands.

7. A functional module, characterized in that it comprises:
– a plurality of components (50),
– a plurality of juxtaposed connection devices (91) as claimed in any one of the preceding claims,
– interconnection and attachment means (60) between the components (50) and the connection devices (91),
– mechanical assembly means (81, 71, 72 and 92) for the connection devices ensuring contact of the outside edges, and
– connection means (71) for the functional module with the outside.

8. The functional module as claimed in claim 7, characterized in that the mechanical assembly means (81, 71, 72 and 92) comprise:
– a box (81) at the bottom of which the connection devices (91) are juxtaposed and containing the components (50) and the interconnection and attachment means (60), and
– compression means (92).

9. The module as claimed in claim 8, characterized in that the interconnection and attachment means (60) comprise at least one second sheet of which one face (65) is located on that one (56) of the faces of the components (50) which comprises connection zones and itself comprises first connection zones positioned opposite to those of the component, and whose other face (61) is positioned on that one of the said first faces of the connection device, which is free, and comprises second connection zones positioned opposite to the connection device (91), the first and the second connection zones for the second sheet being electrically connected by paths ensuring at least in part a displacement essentially parallel to the faces of the second sheet, the connection zones of the second sheet having a manufacturing precision intermediate between that of the connection zones of the component (50) and that of the zones (12 and 16) for the connection of one component of the connection device (91 ).

10. The module as claimed in claim 9, characterized in that the dimensions of the second sheet and those of the component (50) substantially parallel to the faces of the second sheet are less than those of the said first sheets (1, 2, 3 and 4) of the connection device (91), something that provides for free spaces (93) in the box (81).

11. The module as claimed in claim 9 or in claim 10, characterized in that the said interconnection and attachment means (60) furthermore comprise welds produced between the said first connection zones of the said second sheet and the connection zones of the component (50), and between the said second interconnection zones of the said second sheet and the zone (12 and 16) for the connection of a component of the connection device (91).

12. The module as claimed in any one of the preceding claims 7 through 11, characterized in that it furthermore comprises cooling means.

13. The module as claimed in claim 12, characterized in that the said cooling means comprises a heat sink plate (72) constituting one of the walls (71) of the box (81).

14. The module as claimed in claim 12 or in claim 13, characterized in that the cooling means comprise channels produced in the said free spaces (93) and within which a heat transfer fluid circulates.

15. The module as claimed in any one of the preceding claims 12 through 14, characterized in that the cooling means comprise a heating conducting and electrically insulating material spread out in the box (81) around the connection devices (91), the components (51) and the said interconnection an d attachment means (60).

16. The module as claimed in any one of the preceding claims 7 through 15, characterized in that each component (50) is an integrated circuit and in that the module comprises furthermore a plurality of capacitors (51) ensuring a decoupling function for the integrated circuits (50), one capacitor (51) being connected and attached to each of the integrated circuits (50).

EP 0 378 016 B1

FIG_1

9

FIG_2

FIG. 3

EP 0 378 016 B1

FIG.4